# EUROPEAN PATENT APPLICATION

(11) **EP 1 850 652 A2**
(43) Date of publication of application: **31.10.2007**
(21) Application number: 07107142.7
(22) Date of filing: 27.04.2007
(51) Int. Cl.: H05K 9/00

(54) **Filter for display apparatus, method of manufacturing the same and plasma display apparatus**

(30) Priority: 28.04.2006 KR 20060039059
(71) Applicant: LG Electronics Inc., Seoul, 150-721 (KR)
(72) Inventor: Cha, Hongrae, SEOUL (KR)
(74) Representative: Cabinet Plasseraud

(57) **Abstract**

A filter for a display apparatus, a method of manufacturing the same, and a plasma display apparatus are disclosed. The filter for the display apparatus includes a base film layer, an electromagnetic interference (EMI) shielding layer, and a resin layer. The EMI shielding layer is formed on the base film layer. The resin layer is formed on the EMI shielding layer.

## Description

### BACKGROUND

### Field

This document relates to a display apparatus, and more particularly, to a filter for a display apparatus, a method of manufacturing the same, and a plasma display apparatus.

### Description of the Related Art

Out of display apparatuses, a plasma display apparatus comprises a plasma display panel and a driver for driving the plasma display panel.

The plasma display panel has the structure in which barrier ribs formed between a front panel and a rear panel form unit discharge cell or discharge cells. Each discharge cell is filled with an inert gas containing a main discharge gas such as neon (Ne), helium (He) or a mixture of Ne and He, and a small amount of xenon (Xe).

The plurality of discharge cells form one pixel. For example, a red (R) discharge cell, a green (G) discharge cell, and a blue (B) discharge cell form one pixel.

When the plasma display panel is discharged by a high frequency voltage, the inert gas generates vacuum ultraviolet rays, which thereby cause phosphors formed between the barrier ribs to emit light, thus displaying an image. Since the plasma display panel can be manufactured to be thin and light, it has attracted attention as a next generation display device.

The display apparatuses each had optical characteristics depending on their kinds, and had a problem of the generation of reflective light in their display surfaces by external light. Furthermore, the display apparatuses had another problem that electromagnetic waves or near-infrared rays are emitted from the display surface when the display apparatuses display images.

To mitigate the above problems, the display apparatuses had a filter on the display surface. The filter was composed of a plurality of function layers, each of which solves the aforementioned problems, respectively.

This filter was manufactured by separately manufacturing each of the function layers and stacking the manufactured function layers using an adhesive. Accordingly, the number of processes for forming the filter increases due to processes for forming the plurality of function layers and processes for stacking the plurality of function layers. This results in a reduction in yield rate of production, and an increase in production costs of the display apparatuses.

### SUMMARY

In one aspect, a filter for a display apparatus comprises a base film layer, an electromagnetic interference (EMI) shielding layer formed on the base film layer, and a resin layer formed on the EMI shielding layer.

In another aspect, a plasma display apparatus comprises a plasma display panel, and a filter formed on the plasma display panel, the filter comprising a base film layer, an EMI shielding layer formed on the base film layer, and a resin layer formed on the EMI shielding layer.

In still another aspect, a method of manufacturing a filter for a display apparatus comprises forming an EMI shielding layer on a base film layer, and forming a resin layer on the EMI shielding layer.

### BRIEF DESCRIPTION OF THE DRAWINGS

The accompany drawings, which are included to provide a further understanding of the invention and are incorporated on and constitute a part of this specification, illustrate embodiments of the invention and together with the description serve to explain the principles of the invention. In the drawings:

FIG. 1 illustrates a filter for a display apparatus according to an embodiment;

FIGs. 2a to 2e illustrate a method of manufacturing the filter for the display apparatus according to an embodiment;

FIG. 3 illustrates a filter for a display apparatus according to another embodiment; and

FIG. 4 illustrates a plasma display apparatus according to an embodiment.

### DETAILED DESCRIPTION OF PREFERRED EMBODIMENTS

Reference will now be made in detail embodiments of which are illustrated in the accompanying drawings.

A filter for a display apparatus comprises a base film layer, an electromagnetic interference (EMI) shielding layer formed on the base film layer, and a resin layer formed on the EMI shielding layer.

The EMI shielding layer may be a mesh type or a conductive type.

The resin layer may be a thermosetting resin layer.

The resin layer may be formed on the remaining EMI shielding layer except a ground portion of the EMI shielding layer.

The resin layer may comprise at least one of a near infrared ray shielding material, an orange wavelength absorption material, or a color control material.

The filter for the display apparatus may further comprise a non-reflection layer formed on the resin layer.

The filter for the display apparatus may further comprise an adhesive layer formed on a rear surface of the base film layer.

The adhesive layer may comprise at least one of a near infrared ray shielding material, an orange wavelength absorption material, or a color control material.

A plasma display apparatus comprises a plasma display panel, and a filter formed on the plasma display panel, the filter comprising a base film layer, an EMI shielding layer formed on the base film layer, and a resin layer formed on the EMI shielding layer.

The EMI shielding layer may be a mesh type or a conductive type.

The resin layer may be a thermosetting resin layer.

The resin layer may be formed on the remaining EMI shielding layer except a ground portion of the EMI shielding layer.

The resin layer may comprise at least one of a near infrared ray shielding material, an orange wavelength absorption material, or a color control material.

The filter for the display apparatus may further comprise a non-reflection layer formed on the resin layer.

The filter for the display apparatus may further comprise an adhesive layer formed on a rear surface of the base film layer.

The adhesive layer may comprise at least one of a near infrared ray shielding material, an orange wavelength absorption material, or a color control material.

A method of manufacturing a filter for a display apparatus comprises forming an EMI shielding layer on a base film layer, and forming a resin layer on the EMI shielding layer.

The method may further comprise forming a non-reflection layer on the resin layer, and forming an adhesive layer on a rear surface of the base film layer.

The EMI shielding layer may be a mesh type or a conductive type, and the EMI shielding layer may be formed using one of a photolithographic etching method, a printing method, a plating method, an off-set method, an inkjet method, and a vacuum deposition method.

Forming the resin layer may comprise coating thermosetting resin mixed in at least one of a near infrared ray shielding material, an orange wavelength absorption material, or a color control material on the remaining EMI shielding layer except a ground portion of the EMI shielding layer, and hardening the thermosetting resin.

Hereinafter, exemplary embodiments of the present invention will be described in detail with reference to the attached drawings.

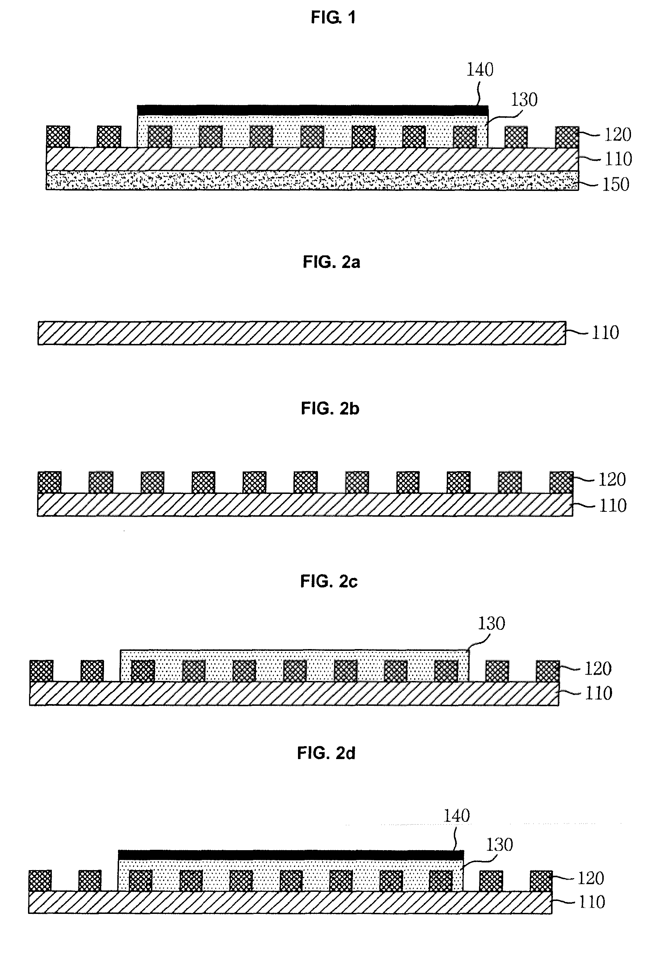

FIG. 1 illustrates a filter for a display apparatus according to an embodiment.

As illustrated in FIG. 1, the filter for the display apparatus according to an embodiment comprises a base film layer 110, an electromagnetic interference (EMI) shielding layer 120, and a resin layer 130.

The base film layer 110 may be formed of a transparent material film such as polyethyleneterephthalate (PET) and tantalum carbide (TAC).

The EMI shielding layer 120 prevents electromagnetic waves generated when driving the display apparatus from being emitted to the outside through a display surface of the display apparatus.

The EMI shielding layer 120 is directly formed on the base film layer 110. This is to remove an adhesive layer necessary to form the EMI shielding layer 120 on the base film layer 110.

Further, the EMI shielding layer 120 is formed in a mesh type. The mesh type EMI shielding layer 120 is formed by forming a metal layer with conductivity in a mesh pattern form. The mesh type EMI shielding layer 120 has a ground portion for grounding the metal layer of the mesh pattern at an end portion thereof.

The resin layer 130 prevents near infrared rays generated when driving the display apparatus from being emitted to the outside through the display surface of the display apparatus, absorbs an orange wavelength of 590 nm, and controls colors expressed by optical characteristics of the display apparatus.

The resin layer 130 may be formed of transparent resin comprising at least one of a near infrared ray shielding material, an orange wavelength absorption material, or a color control material.

Moreover, the resin layer 130 may not comprise unnecessary material among the near infrared ray shielding material, the orange wavelength absorption material, and the color control material depending on characteristics of the display apparatus having the filter. The resin layer 130 may further comprise a material having another function in addition to the materials whenever necessary.

As above, since the resin layer 130 has various functions, the number of function layers of the filter is reduced. A reduction in the number of function layers reduces the number of adhesive layers for adhering the function layers to one another.

The resin layer 130 having various function materials is directly formed on the messy type EMI shielding layer 120. This is to remove an adhesive layer necessary to form the resin layer 130 on the messy type EMI shielding layer 120. The resin layer 130 is not formed on the ground portion of the messy type EMI shielding layer 120.

The filter for the display apparatus according to an embodiment, as illustrated in FIG. 1, may further comprise a non-reflection layer 140 and an adhesive layer 150.

The non-reflection layer 140 is formed on the resin layer 130. The non-reflection layer 140 is formed of at least one of an anti-reflection layer, an anti-glare layer, or a multiple layer of an anti-reflection layer and an anti-glare layer. The anti-reflection layer vanishes external light using a plurality of layers each having a different refraction index. The anti-glare layer diffuses external light using a layer having a concavo-convex portion formed on the surface thereof.

The adhesive layer 150 is formed on a rear surface of the base film layer 110, and used to adhere the filter to the display apparatus. The adhesive layer 150 may comprise at least one of the near infrared ray shielding material, the orange wavelength absorption material or the color control material, whenever necessary. In this case, the material which the adhesive layer 150 comprises may be excluded from the material forming the resin layer 130.

FIGs. 2a to 2e illustrate a method of manufacturing the filter for the display apparatus according to an embodiment.

As illustrated in FIGs. 2a to 2e, the EMI shielding layer 120 and the resin layer 130 are directly formed on the base film layer 110 in the order named.

First, as illustrated in FIG. 2a, the base film layer 110 is formed. The base film layer 110 is formed of a transparent PET film or a transparent TAC film, and the like.

As illustrated in FIG. 2b, the mesh type EMI shielding layer 120 is directly formed on the base film layer 110.

The mesh type EMI shielding layer 120 can be formed by directly forming a mesh pattern on the base film layer 110. Moreover, the mesh type EMI shielding layer 120 can be formed by forming a metal layer, and then removing an unnecessary portion from the metal layer using an etching process. The direct formation of the mesh pattern uses a printing method, an off-set method, an inkjet method, a plating method, a vacuum deposition method, and the like.

As illustrated in FIG. 2c, the resin layer 130 is directly formed on the EMI shielding layer 120. The direct formation of the resin layer 130 may use curable resin obtained by mixing materials each having a different function.

Below, the explanation will be given of an example of a method of using thermosetting resin.

At least one of a dye or a pigment having a near infrared ray shielding function, a dye or a pigment having an orange wavelength absorption function, or a dye or a pigment having a color control function is mixed in thermosetting resin.

The thermosetting resin is coated on the mesh type EMI shielding layer 120. In this case, the thermosetting resin is not coated on the ground portion of the mesh type EMI shielding layer 120. The coated thermosetting resin is then planarized.

The planarized thermosetting resin is hardened to complete the resin layer 130. The curable resin may use polymethylmethacrylate (PMMA), acryl, EVA, and the like. Kinds of the above-described dye or pigment may vary depending on the setting of transmissivity of the filter.

Although the filter for the display apparatus according to an embodiment comprised the thermosetting resin, the filter may comprise another material as the resin layer 130. Further, the resin layer 130 may be formed using another method as long as on the resin layer is directly formed on the EMI shielding layer 120.

As illustrated in FIG. 2d, the non-reflection layer 140 is formed on the resin layer 130. The non-reflection layer 140, as illustrated in FIG. 1, is formed of at least one of an anti-reflection layer, an anti-glare layer, or a multiple layer of an anti-reflection layer and an anti-glare layer.

The multiple layer of the anti-reflection layer and the anti-glare layer is formed by coating the anti-glare layer and then coating the anti-reflection layer. A dry coating method or a wet coating method may be used.

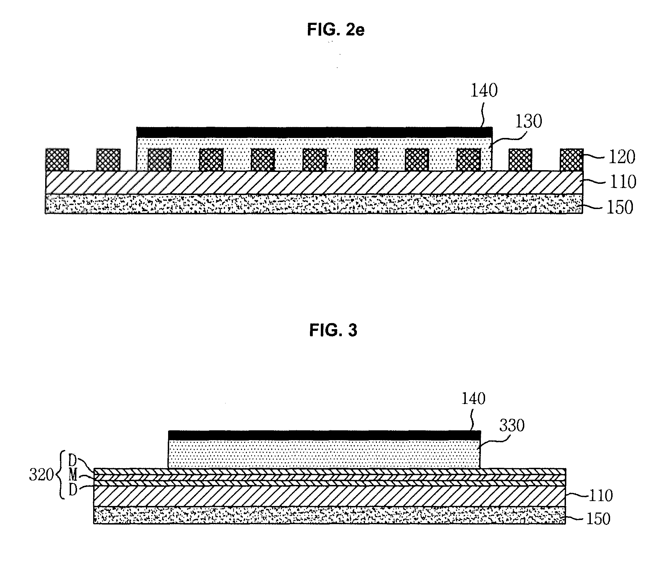

As illustrated in FIG. 2e, the adhesive layer 150 is formed on the rear surface of the base film layer 110. Although a process for forming the adhesive layer 150 was lastly performed in the method of manufacturing the filter, the process for forming the adhesive layer 150 may be firstly performed or may be performed between the above processes for manufacturing the filter, whenever necessary.

In a case where the adhesive layer 150 comprises at least one of the near infrared ray shielding material, the orange wavelength absorption material, or the color control material, the resin layer 130 can not comprise the material which the adhesive layer 150 comprises.

As above, since the number of function layers and the number of processes for stacking the function layers are reduced, there are an increase in yield rate of production and a reduction in production cost of the display apparatus.

FIG. 3 illustrates a filter for a display apparatus according to another embodiment.

As illustrated in FIG. 3, the filter for the display apparatus according to another embodiment comprises a base film layer 110, an EMI shielding layer 320, and a resin layer 330. Descriptions of structures and components illustrated in FIG. 3 identical or equivalent to those illustrated in FIG. 1 is briefly made or is entirely omitted.

The EMI shielding layer 320 is directly formed on the base film layer 110. Accordingly, an adhesive layer necessary to form the EMI shielding layer 320 on the base film layer 110 can be removed.

The EMI shielding layer 320 is formed in a conductive type. The conductive type EMI shielding layer 320 has a stacking structure ((DMD)n) of a dielectric layer D and a metal layer M.

The dielectric layer D is formed of a transparent conductive material such as indium-tin-oxide (ITO) and ZnO. The metal layer M is formed of a metal with low resistance such as Ag. As a value of "n" in the stacking structure ((DMD)n) increases (i.e., the number of layers for forming the EMI shielding layer 320 increases), while a resistance of the EMI shielding layer 320 is reduced, production cost increases. Therefore, an optimum value of "n" is determined in consideration of the above conditions.

Since the conductive type EMI shielding layer 320 has not only an EMI shielding function but also a near infrared absorption function, the resin layer 330 may not comprise a near infrared shielding material.

In this case, the conductive type EMI shielding layer 320 is formed by repeatedly stacking Ag and ITO using a sputtering method.

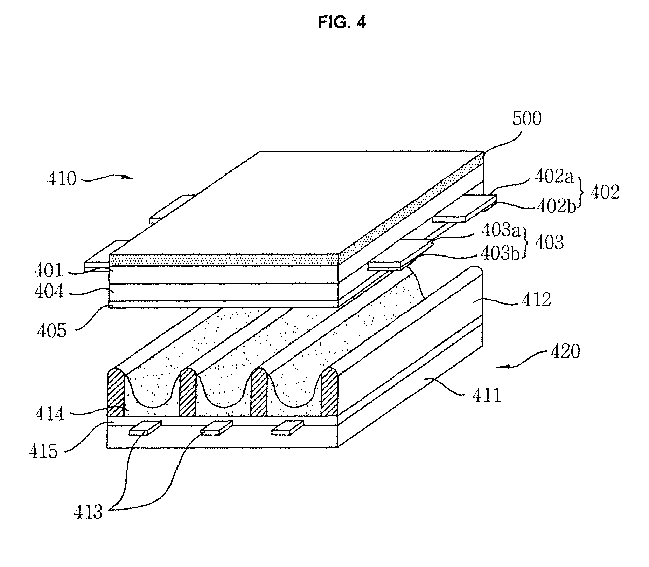

FIG. 4 illustrates a plasma display apparatus according to an embodiment.

As illustrated in FIG. 4, the plasma display apparatus according to an embodiment comprises a plasma display panel and a filter 500 positioned on the plasma display panel.

The plasma display panel comprises a front panel 410 and a rear panel 420 which are coupled in parallel to oppose to each other at a given distance therebetween. The front panel 410 comprises a front substrate 401 which is a display surface displaying an image. The rear panel 420 comprises a rear substrate 411 constituting a rear surface. A plurality of scan electrodes 402 and a plurality of sustain electrodes 403 are formed in pairs on the front substrate 101 to form a plurality of maintenance electrode pairs. A plurality of address electrodes 413 are arranged on the rear substrate 411 to intersect the plurality of maintenance electrode pairs.

The scan electrode 402 and the sustain electrode 403 each comprise transparent electrodes 402a and 403a made of a transparent ITO material and bus electrodes 402b and 403b made of a metal material. The scan electrode 402 and the sustain electrode 403 are covered with an upper dielectric layer 404, and a protective layer 405 is formed on the upper dielectric layer 404.

The rear panel 420 comprises barrier ribs 412 for partitioning discharge cells. The plurality of address electrodes 413 are arranged in parallel to the barrier ribs 412. Red (R), green (G) and blue (B) phosphors 414 are coated on the address electrodes 413.

A lower dielectric layer 415 is formed between the address electrodes 413 and the phosphors 414. FIG. 4 has illustrated an example of the structure of the plasma display panel. Therefore, the electrode structure or the barrier rib structure may vary whenever necessary.

The barrier ribs 412 formed between the front panel 410 and the rear panel 420 form unit discharge cell or discharge cells. Each discharge cell is filled with an inert gas containing a main discharge gas such as neon (Ne), helium (He) or a mixture of Ne and He, and a small amount of xenon (Xe).

When the plasma display panel is discharged by a high frequency voltage, the inert gas generates vacuum ultraviolet rays, which thereby cause the phosphors 414 formed between the barrier ribs 412 to emit light, thus displaying an image.

A frame (not illustrated) and a driver (not illustrated), and the like, are installed on the rear surface of the plasma display panel to manufacture a plasma display module. A case (not illustrated) for determining an outward shape is installed in the plasma display module to complete the plasma display apparatus.

Since the plasma display apparatus with the above-described structure displays the image due to the application of the high frequency voltage for generating a plasma discharge, electromagnetic waves emitted through the display surface of the plasma display apparatus is much more than those in color ray tubes (CRTs) or liquid crystal displays (LCDs).

The plasma display apparatus emits near infrared rays induced from the inert gas such as Ne and Xe, and a wavelength of the near infrared rays is very close to a wavelength of a remote controller of electric home appliances. Therefore, it is likely to cause the malfunction of the electric home appliances. Further, the quantity of light with an orange wavelength emitted from the plasma display apparatus is more than that in the display apparatuses such as the CRT and the LCD because of characteristics of the phosphor of the plasma display apparatus.

Accordingly, the plasma display apparatus according to an embodiment comprises the filter for the display apparatus illustrated in FIGs. 1 or 3 on the plasma display panel.

The filter 500 of the plasma display apparatus according to an embodiment comprises a base film layer, an EMI shielding layer directly formed on the base film layer, and a resin layer, directly formed on the EMI shielding layer, comprising at least one of a near infrared ray shielding material, an orange wavelength absorption material or a color control material.

Since the structure and a manufacturing method of the filter 500 are fully described in FIGs. 1 to 3, a description thereof is omitted. As above, since the plasma display apparatus comprises the filter for the display apparatus according to an embodiment, the plasma display apparatus has a great effect in the shielding of the electromagnetic waves, compared with the display apparatuses such as the CRTs and the LCDs. Further, yield rate of production of the plasma display apparatus increases and production cost of the plasma display apparatus reduces.

FIG. 4 has illustrated the case whether the filter 500 is directly attached to the plasma display panel. However, the filter 500 may be spaced apart from the plasma display panel.

In the filter 500 for the display apparatus according to an embodiment, function layers for improving the plasma display apparatus are not manufactured separately, and the function layers are directly formed on one base film layer.

The filter used in the plasma display apparatus is required to have more functions than filters used in the display apparatuses.

Accordingly, since the plasma display apparatus comprises the filter for the display apparatus according to an embodiment, there are an increase in yield rate of production and a reduction in production cost of the plasma display apparatus.

## Claims

1. A filter for a display apparatus comprising:
a base film layer;
an electromagnetic interference (EMI) shielding layer formed on the base film layer; and
a resin layer formed on the EMI shielding layer.

2. The filter for the display apparatus of claim 1, wherein the EMI shielding layer is a mesh type or a conductive type.

3. The filter for the display apparatus of claim 1, wherein the resin layer is a thermosetting resin layer.

4. The filter for the display apparatus of claim 1, wherein the resin layer is formed on the remaining EMI shielding layer except a ground portion of the EMI shielding layer.

5. The filter for the display apparatus of claim 1, wherein the resin layer comprises at least one of a near infrared ray shielding material, an orange wavelength absorption material, or a color control material.

6. The filter for the display apparatus of claim 1, further comprising a non-reflection layer formed on the resin layer.

7. The filter for the display apparatus of claim 1, further comprising an adhesive layer formed on a rear surface of the base film layer.

8. The filter for the display apparatus of claim 7, wherein the adhesive layer comprises at least one of a near infrared ray shielding material, an orange wavelength absorption material, or a color control material.

9. A plasma display apparatus comprising:
a plasma display panel; and
a filter formed on the plasma display panel, the filter comprising a base film layer, an EMI shielding layer formed on the base film layer, and a resin layer formed on the EMI shielding layer.

10. The filter for the display apparatus of claim 9, wherein the EMI shielding layer is a mesh type or a conductive type.

11. The filter for the display apparatus of claim 9, wherein the resin layer is a thermosetting resin layer.

12. The filter for the display apparatus of claim 9, wherein the resin layer is formed on the remaining EMI shielding layer except a ground portion of the EMI shielding layer.

13. The filter for the display apparatus of claim 9, wherein the resin layer comprises at least one of a near infrared ray shielding material, an orange wavelength absorption material, or a color control material.

14. The filter for the display apparatus of claim 9, further comprising a non-reflection layer formed on the resin layer.

15. The filter for the display apparatus of claim 9, further comprising an adhesive layer formed on a rear surface of the base film layer.

16. The filter for the display apparatus of claim 15, wherein the adhesive layer comprises at least one of a near infrared ray shielding material, an orange wavelength absorption material, or a color control material.

17. A method of manufacturing a filter for a display apparatus comprising:
forming an EMI shielding layer on a base film layer; and
forming a resin layer on the EMI shielding layer.

18. The method of claim 17, further comprising
forming a non-reflection layer on the resin layer, and
forming an adhesive layer on a rear surface of the base film layer.

19. The method of claim 17, wherein the EMI shielding layer is a mesh type or a conductive type, and
the EMI shielding layer is formed using one of a photolithographic etching method, a printing method, a plating method, an off-set method, an inkjet method, and a vacuum deposition method.

20. The method of claim 17, wherein forming the resin layer comprises
coating thermosetting resin mixed in at least one of a near infrared ray shielding material, an orange wavelength absorption material, or a color control material on the remaining EMI shielding layer except a ground portion of the EMI shielding layer, and
hardening the thermosetting resin.
